# EUROPÄISCHE PATENTANMELDUNG

(11) **EP 1 551 037 A1**
(43) Veröffentlichungstag der Anmeldung: **06.07.2005**
(21) Anmeldenummer: 04405004.5
(22) Anmeldetag: 05.01.2004
(51) Int. Cl.: H01B 7/08, H05K 3/20, H05K 3/46

(54) **Flexibler Träger mit elektrisch leitfähiger Struktur**

(71) Anmelder: Alcan Technology & Management Ltd., 8212 Neuhausen am Rheinfall (CH)
(72) Erfinder: Ziegler, Andreas, 8234 Stetten (CH); Dörr, Norman, 78256 Steisslingen (DE); Hammon, Werner, 78333 Stockach (DE); Lüthi, Markus, 8460 Marthalen (CH); Lohwasse, Wolfgang, 78262 Gailingen (DE); Reinhold, Matthias, 8212 Neuhausen (CH)

(57) **Zusammenfassung**

Bei einem flexiblen Träger (10) mit einer Basisschicht (12) aus Kunststoff und wenigstens einer mit elektrisch leitfähiger Farbe zumindest auf der Basisschicht (12) einseitig aufgedruckten, elektrisch leitfähigen Struktur (20) ist die wenigstens eine elektrisch leitfähige Struktur (20) zwischen der Basisschicht (12) und wenigstens einer Deckschicht (14) aus Kunststoff und jede der gegebenenfalls weiteren elektrisch leitfähigen Strukturen (22) zwischen jeweils zwei aufeinander der folgenden weiteren Deckschichten angeordnet, und die Basisschicht (12) ist mit der wenigsten einen Deckschicht (14) und jede der gegebenenfalls weiteren Deckschichten ist mit den angrenzenden Deckschichten verbunden.

## Beschreibung

Die Erfindung betrifft einen flexiblen Träger mit einer Basisschicht aus Kunststoff und wenigstens einer mit elektrisch leitfähiger Farbe zumindest auf der Basisschicht einseitig aufgedruckten, elektrisch leitfähigen Struktur und ein Verfahren zum kontinuierlichen Aufdrucken der elektrisch leitfähigen Struktur auf den flexiblen Träger.

In der Vergangenheit war zur Herstellung gedruckter Schaltungen oder Leiterplatten ein Verfahren bekannt, bei dem das Schaltsystem bzw. der Stromkreis mit einer elektrisch leitfähigen Farbe direkt positiv auf eine elektrisch nicht leitende Kunststoffplatte aufgedruckt wurde, so dass die Druckfarbe die Funktion isolierter Drähte übernahm. Zu den bekannten, elektrisch leitfähigen Farben gehören die so genannten "Silberlacke", die im Siebdruckverfahren auf die Platten aufgedruckt wurden. Hierzu wurde den Siebdrucklacken so viel feines Silberpulver zugemischt, bis der angestrebte Leitwert erreicht werden konnte.

Bekannt sind auch aus mehreren übereinander liegenden Folienschichten hergestellte Sensoren. Diese bestehen beispielsweise aus einer Polyesterfolie als Basismaterial, auf der ein Widerstandskörper aus einem elektrisch leitfähigen Widerstandsmaterial in Siebdrucktechnik aufgebracht ist. In Abstand zu dieser Basisfolie ist eine elastische Deckfolie aus beispielsweise Polyoxymethylen, die ebenfalls mit einem elektrisch leitfähigen Material als Gegenelektrode beschichtet ist und durch Abstandshalter in geringem Abstand vom Widerstandskörper getrennt gehalten wird.

Aus der EP-B-0 129 785 ist eine Folienpackung als Arzneimittelbehälter mit auf die Folie aufgebrachten Leiterbahnen für eine elektrische Kontaktierung mit einem Signalgeber bekannt. Die Anordnung dient zur Kontrolle der Medikamenteneinnahme durch einen Patienten.

Der Erfindung liegt die Aufgabe zugrunde, einen flexiblen Träger der eingangs genannten Art zu schaffen, der einfach und kostengünstig hergestellt werden kann. Ein weiteres Ziel der Erfindung liegt in der Schaffung eines flexiblen Trägers in der Form eines gegen Witterungseinflüsse beständigen Flachbandkabels. Nach einem anderen Ziel der Erfindung soll das Flachbandkabel die Vorteile eines konventionellen elektrischen Kabels mit verdrillten Stromleitern und/oder mit einer elektromagnetischen Abschirmung aufweisen.

Zur erfindungsgemässen Lösung der Aufgabe führt, dass die wenigstens eine elektrisch leitfähige Struktur zwischen der Basisschicht und wenigstens einer Deckschicht aus Kunststoff und jede der gegebenenfalls weiteren elektrisch leitfähigen Strukturen zwischen jeweils zwei aufeinander folgenden weiteren Deckschichten angeordnet und die Basisschicht mit der wenigsten einen Deckschicht und jede der gegebenenfalls weiteren Deckschichten mit den angrenzenden Deckschichten verbunden ist.

Bei einer bevorzugten Ausgestaltung des erfindungsgemässen flexiblen Trägers weist die wenigstens eine Deckschicht wenigstens eine weitere, mit elektrisch leitfähiger Farbe auf der wenigstens einen Deckschicht aufgedruckte elektrisch leitfähige Struktur auf, und zwischen den elektrisch leitfähigen Strukturen ist jeweils eine elektrisch isolierende Zwischenschicht aus Kunststoff angeordnet.

Bei einer besonders zweckmässigen Ausführungsform ist die wenigstens eine Deckschicht mit der wenigstens einen weiteren elektrisch leitfähigen Struktur von der wenigstens einmal um sich selbst gefalteten Basisschicht mit der elektrisch leitfähigen Struktur gebildet.

Eine andere bevorzugte Ausführungsform besteht darin, dass der flexible Träger eingerollt ist.

Bei einer zweckmässigen Ausgestaltung des flexiblen Trägers als Flachbandkabel sind die elektrisch leitfähigen Strukturen sich mehrfach kreuzende Leiterbahnen, die in Analogie zu der bekannten Verdrillung von elektrischen Leitern eine Reduktion von elektrischen und magnetischen Feldern bewirken.

Die Basisschicht und die wenigstens eine Deckschicht oder bei weiteren Deckschichten zumindest die von der Basisschicht am weitesten entfernte Deckschicht können je eine Barriereschicht als Durchtrittssperre für Wasserdampf aufweisen.

Als Barriereschicht können grundsätzlich alle als Durchtrittssperre für Wasserdampf geeigneten Sperrschichten eingesetzt werden. Zu den besonders bevorzugten Barriereschichten gehören Schichten aus wenigstens einem der Stoffe Aluminium, Al₂O₃ oder SiOₓ mit 0.9 < x < 2, insbesondere 1.2 < x < 1.8.

Ein als besonders robuster, wasserdampfundurchlässiger und elektromagnetische Abschirmeigenschaften aufweisender flexibler Träger weist eine Barriereschicht in Form einer Aluminiumfolie auf, die mit der Basisschicht und der wenigstens einen Deckschicht oder bei weiteren Deckschichten zumindest mit der von der Basisschicht am weitesten entfernten Deckschicht verbunden und von der elektrisch leitfähigen Struktur elektrisch getrennt ist. Hierbei kann die Aluminiumfolie grundsätzlich innerhalb eines mehrschichtigen Folienverbundes angeordnet sein. Bevorzugt ist jedoch eine Anordnung, bei der die Aluminiumfolie auf der Aussenseite der Basisschicht und der von der Basisschicht am weitesten entfernten Deckschicht angeordnet ist.

Grundsätzlich kann die als Barriereschicht eingesetzte Aluminiumfolie bei der Herstellung des flexiblen Trägers auch als Substrat eingesetzt werden, auf welches die Basis- oder die Deckschicht durch eine Extrusionsbeschichtung oder als Lackschicht aufgebracht wird, wobei im Fall einer Lackschicht eine zweifache Lackierung bevorzugt wird.

Barriereschichten können auch als aus dem Vakuum abgeschiedene Schichten innerhalb oder auf der Aussenseite der Basisschicht und der Deckschicht angeordnet sein.

Das kontinuierliche Aufdrucken der elektrisch leitfähigen Struktur mit elektrisch leitfähiger Farbe auf den flexiblen Träger aus Kunststoff erfolgt bevorzugt im Tiefdruckverfahren. Durch besonders tief geätzte oder gravierte Tiefdruckzylinder kann bereits durch eine einmalige Bedruckung eine Struktur mit guter elektrischer Leitfähigkeit erzeugt werden. Zur weiteren Erhöhung der Leitfähigkeit kann die Struktur mehrfach übereinander gedruckt werden. Zweckmässigerweise ist dabei der Rand jeder aufgedruckten Struktur gegenüber dem Rand der darunter liegenden Struktur unter Ausbildung einer Stufe zurückversetzt, so dass sich beim Auftragen eines elektrisch isolierenden Lackes auf die Struktur ein geglätteter Übergang zwischen der Basis- bzw. Deckschicht und der elektrisch leitfähigen Druckfarbe ergibt.

Den mit der vorliegenden Erfindung geschaffenen wasserdichten, flexiblen und kostengünstig herstellbaren Trägern mit elektrisch leitfähiger Struktur eröffnet sich ein breites Anwendungsgebiet von der Hochfrequenz-Stromübertragung mit Flachbandkabeln bis zu Heizmatten in Fussbodenheizungen.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in
- - Fig. 1: einen Schnitt durch eine erste Ausführungsform eines flexiblen Trägers mit aufgedruckter elektrisch leitfähiger Struktur;
- - Fig. 2: einen Schnitt durch eine zweite Ausführungsform eines flexiblen Trägers mit aufgedruckter, elektrisch leitfähiger Struktur;
- - Fig. 3: ein erstes Verfahren zur kontinuierlichen Herstellung eines Flachbandkabels mit sich überkreuzenden Leiterbahnen;
- - Fig. 4 - 6: ein zweites Verfahren zur kontinuierlichen Herstellung eines Flachbandkabels mit sich kreuzenden Leiterbahnen;
- - Fig. 7: den Querschnitt durch das Flachbandkabel von Fig. 6 nach deren Linie I-I;
- - Fig. 8: ein drittes Verfahren zur kontinuierlichen Herstellung eines Flachbandkabels mit sich kreuzenden Leiterbahnen;
- - Fig. 9: eine Schrägsicht auf ein eingerolltes Flachbandkabel;
- - Fig. 10: den Querschnitt durch ein zweiadriges elektrisches Kabel mit an diesem angeordneten Flachbandkabel;
- - Fig. 11: einen Schnitt durch ein Flachbandkabel mit mehrfach übereinander gedruckten Leiterbahnen.

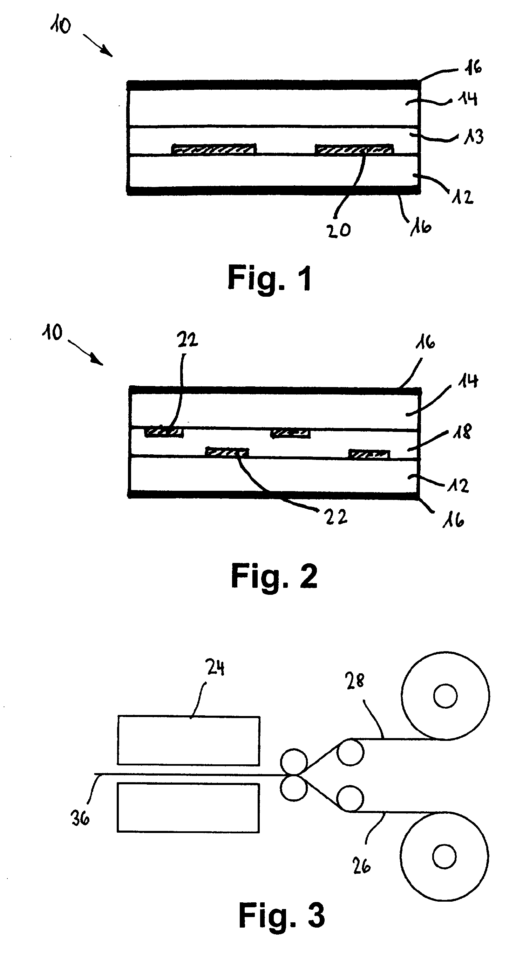

Eine erste Ausführungsform eines flexiblen Trägers 10 umfasst gemäss Fig. 1 eine Basisschicht 12, deren eine Seite mit einer Barriereschicht 16 aus beispielsweise einer Aluminiumfolie verbunden ist, und deren andere Seite mit einer elektrisch leitfähigen Struktur 20 in der Form von beispielsweise elektrischen Leiterbahnen aus elektrisch leitender Farbe bedruckt ist. Die bedruckte Seite der Basisschicht 12 ist über eine Zwischenschicht 13 in Form eines Permanentklebers auf beispielsweise Polyurethanbasis mit einer Deckschicht 14 aus beispielsweise Polyethylen verklebt. Die Deckschicht 14 ist auf der der Verklebung abgewandten Seite ebenfalls mit einer Barriereschicht 16 in Form einer Aluminiumfolie verbunden. Die beiden aussen liegenden Aluminiumfolien verhindern ein Eindringen von Wasserdampf in die Basisschicht 12, in die Deckschicht 14 sowie in die Zwischenschicht 13 und damit ein Vordringen bis zur aufgedruckten Struktur 20. Gleichzeitig bilden die aussen liegenden Aluminiumfolien eine elektromagnetische Abschirmung der dazwischen liegenden elektrisch leitfähigen Struktur 20.

Eine in Fig. 2 dargestellte zweite Ausführungsform eines flexiblen Trägers 10 weist eine Basisschicht 12 aus beispielsweise Polyethylen auf, deren eine Seite mit einer Aluminiumfolie als Barriereschicht 16 verbunden ist. Die Basisschicht 12 ist auf der nicht mit der Barriereschicht 16 verbundenen Seite mit einer elektrisch leitfähigen Struktur 20 in der Form elektrischer Leiterbahnen aus elektrisch leitender Farbe bedruckt. Auf der mit der elektrisch leitfähigen Struktur 20 versehenen Seite der Basisschicht 12 ist eine elektrisch isolierende Zwischenschicht 18 aus Kunststoff, beispielsweise aus Polyethylen, angeordnet. In gleicher Weise wie die Basisschicht 12 ist eine aussenseitig mit einer Aluminiumfolie als Barriereschicht 16 ausgestattete Deckschicht 14 aus beispielsweise Polyethylen mit einer weiteren elektrisch leitfähigen Struktur 22 versehen. Eine Zwischenschicht 18 aus beispielsweise einem elektrisch isolierenden Kleber auf Polyolefinbasis ist zwischen der elektrisch leitfähigen Struktur 20 der Basisschicht 12 und der weiteren elektrisch leitfähigen Struktur 22 der Deckschicht 14 angeordnet. Ein derartiger symmetrisch aufgebauter Träger 10 lässt sich auf einfache Weise dadurch erzeugen, dass die Basisschicht 12 entlang einer symmetrisch angeordneten Faltlinie um 180° um sich selbst gefaltet wird, so dass die Deckschicht 14 mit der innen liegenden elektrisch leitfähigen Struktur 22 und der aussen liegenden Aluminiumfolie als Barriereschicht 16 ebenfalls von der Basisschicht 12 mit der innen liegenden elektrisch leitfähigen Struktur 20 und der aussen liegenden Aluminiumfolie als Barriereschicht 16 gebildet ist.

Als Material für die Basisschicht 12 und die Deckschicht 14 eignen sich neben Polyethylen und Polypropylen insbesondere auch Polyester.

Bei dem in Fig. 3 dargestellten Verfahren zur Herstellung eines Flachbandkabels 36 mit sich mehrfach kreuzenden Leiterbahnen wird vorgängig eine Kunststofffolie als Basisschicht 12 mit einer Barriereschicht 16 versehen, nachfolgend mit einer ersten Leiterbahn 20a aus elektrisch leitfähiger Farbe bedruckt und nachfolgend mit einem isolierenden Lack als Isolationsschicht 18 überlackiert. In gleicher Weise wird eine zweite Kunststofffolie als Deckschicht 14 mit einer Barriereschicht 16 versehen und mit einer zweiten Leiterbahn 20b bedruckt. Die beiden in Rollenform vorliegenden streifenförmigen Materialien 26, 28 werden so zusammengeführt, dass die beiden Leiterbahnen 20a und 20b einander so gegenüberliegen, dass sie sich in Längsrichtung der Materialstreifen 26, 28 kontinuierlich kreuzen. Die derart zusammengeführten Folienstreifen 26, 28 werden durch eine Heisssiegelvorrichtung 24 geführt und in dieser unter Bildung längs laufender Siegelnähte an den Rändern der Materialstreifen 26, 28 gegeneinander gesiegelt.

Als Barriereschicht 16 wird bevorzugt eine Aluminiumfolie eingesetzt, die mit der Basisschicht 12 bzw. der Deckschicht 14 extrusionskaschiert wird. Eine Heisssiegelung der mit einer Barriereschicht 16 und einer ersten elektrisch leitfähigen Struktur 20 versehenen Basisschicht 12 gegen die mit einer Barriereschicht 16 und einer zweiten elektrisch leitfähigen Struktur 22 versehene Deckschicht 14 kann beispielsweise über einen separaten, zwischen die Materialbahnen 26, 28 eingelegten, heisssiegelfähigen Kunststofffilm erfolgen.

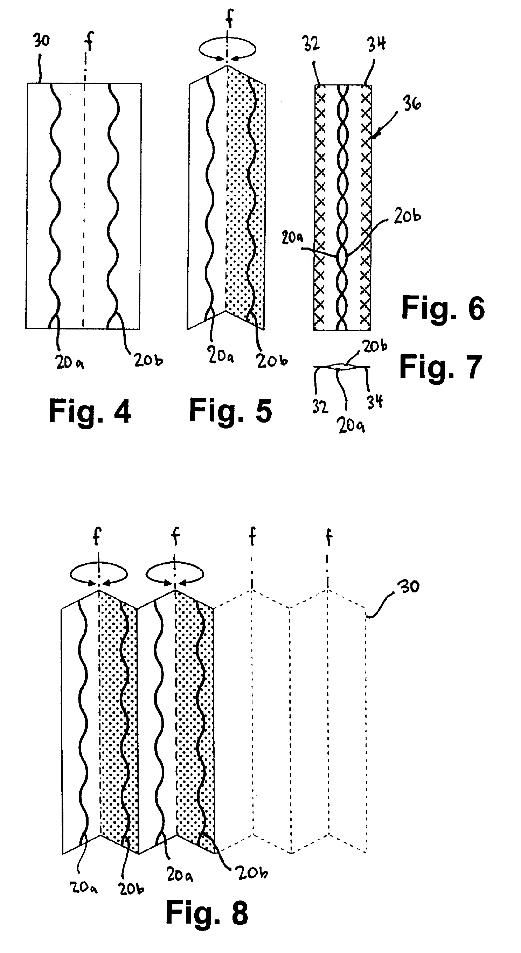

Eine Verfahrensvariante zur kontinuierlichen Herstellung eines Flachbandkabels 36 ist in den Fig. 4 bis 7 dargestellt. Gemäss Fig. 4 wird zunächst ein Materialstreifen 30 bestehend aus einer Basisschicht 12 mit einer Barriereschicht 16 hergestellt und mit zwei Leiterbahnen 20a, 20b bedruckt. Die beiden Leiterbahnen 20a, 20b sind beispielsweise sinusförmige Wellenlinien mit identischen Dimensionen, die beidseits einer Faltachse f und in gleichem Abstand zu dieser parallel zueinander angeordnet sind. Die auf den Materialstreifen 30 aufgedruckten Leiterbahnen 20a, 20b werden nachfolgend mit einem heisssiegelfähigen, elektrisch isolierenden Lack auf beispielsweise Polyolefinbasis beschichtet. Dieses bedruckte und beschichtete Materialband 30 wird gemäss Fig. 5 um die Faltachse f gefaltet, so dass die beiden Leiterbahnen 20a, 20b, wie in Fig. 7 gezeigt, übereinander liegen und sich unter Ausbildung eines regelmässigen Doppelwellenmusters mehrfach kreuzen. In der gefalteten Lage durchläuft das Materialband 30 die Heisssiegelvorrichtung 24 von Fig. 3, in der die Ränder des gefalteten Materialbandes 30 unter Ausbildung von randständigen Siegelnähten 32, 34 kontinuierlich gesiegelt werden.

Fig. 8 zeigt eine auf dem Grundprinzip des in den Fig. 4 bis 7 gezeigten Verfahrens beruhendes Verfahren zur Herstellung eines Flachbandkabels mit einer Vielzahl übereinander angeordneter und sich mehrfach kreuzender Leiterbahnen 20a, 20b. Zunächst wird ein Materialstreifen 30 bestehend aus einer Basisschicht 12 mit einer Barriereschicht 16 hergestellt und mit einer Vielzahl von paarweise einander zugeordneten Leiterbahnen 20a, 20b bedruckt. Die paarweise angeordneten Leiterbahnen 20a, 20b sind -- wie im Beispiel von Fig. 4 -beispielsweise sinusförmige Wellenlinien mit identischen Dimensionen, die beidseits je einer Faltachse f und in gleichem Abstand zu dieser parallel zueinander angeordnet sind. Die auf den Materialstreifen 30 aufgedruckten Leiterbahnen 20a, 20b werden nachfolgend mit einem heisssiegelfähigen, elektrisch isolierenden Lack auf beispielsweise Polyolefinbasis beschichtet. Dieses bedruckte und beschichtete Materialband 30 wird gemäss Fig. 8 zickzackförmig um die Faltachsen f gefaltet, bis alle Leiterbahnenpaare 20a, 20b übereinander liegen und sich paarweise unter Ausbildung eines regelmässigen Doppelwellenmusters mehrfach kreuzen. In dieser mehrfach gefalteten Lage durchläuft das Materialband 30 die Heisssiegelvorrichtung 24 von Fig. 3, in der die Ränder des gefalteten Materialbandes 30 unter Ausbildung von randständigen Siegelnähten im Bereich der Faltachsen kontinuierlich gesiegelt werden.

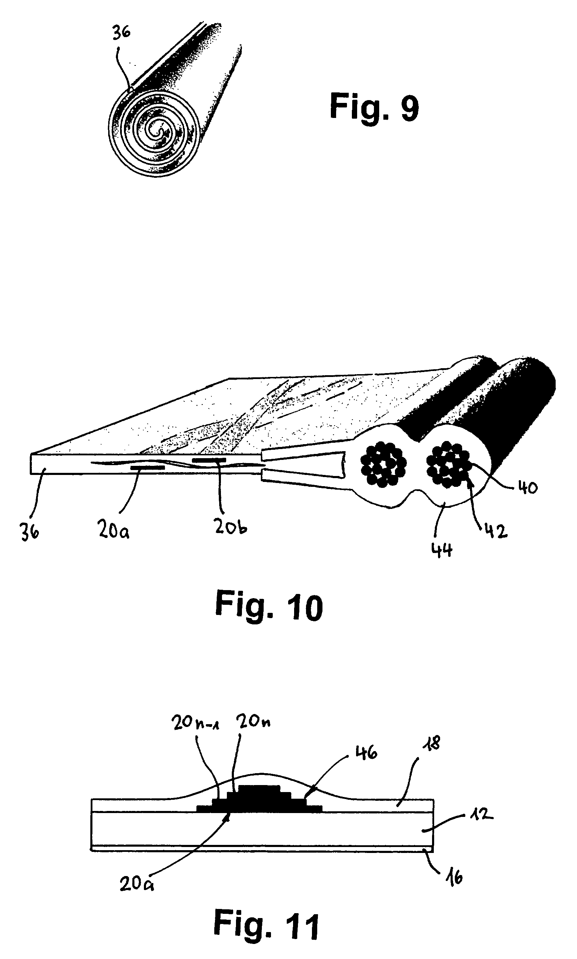

Anstelle einer mehrfachen Überlagerung von sich mehrfach kreuzenden Leiterbahnen 20a, 20b zur Reduktion von störenden elektrischen und magnetischen Feldern kann eine Mehrfachüberlagerung beispielsweise auch dadurch erreicht werden, dass ein Flachbandkabel, wie in Fig. 9 gezeigt, eingerollt wird.

Bei dem in Fig. 10 gezeigten Ausführungsbeispiel ist ein Flachbandkabel 36 mit sich mehrfach kreuzenden Leiterbahnen 20a, 20b mit einem herkömmlichen zweiadrigen Stromkabel 38 mit zwei Strom führenden, aus einzelnen Kupferdrähten 40 aufgebauten Stromleitern 42 und einer Kunststoffummantelung 44 verbunden. Das konventionelle zweiadrige Stromkabel 38 ist für sehr hohe Ströme vorgesehen, die zwei Leiterbahnen 20a, 20b des Flachbandkabels 36 ist beispielsweise für Steuerströme in einem Bussystem vorgesehen.

Zur Erhöhung der elektrischen Leitfähigkeit kann es notwendig sein, eine elektrische Leiterbahn, wie in Fig. 11 dargestellt, mehrfach übereinander zu drucken. Um eine gute Überdeckung der Leiterbahn 20a mit einem elektrisch isolierenden Überzugslack zu erhalten, wird jeder Leiterbahnaufdruck 20ₙ gegenüber dem vorangehenden, darunter liegenden Leiterbahnaufdruck 20ₙ₋₁ etwas schmaler gedruckt, so dass ein abgestufter Rand 46 entsteht, der zu einem im Querschnitt geglätteten und gleichmässigen Lacküberzug 18 führt.

Obschon in den vorangehenden Beispielen ein Flachbandkabel jeweils nur zwei Leiterbahnen 20a, 20b aufweist, ist die vorliegende Erfindung nicht auf die gezeigten Ausführungsformen beschränkt sondern umfasst auch Flachbandkabel mit einer Vielzahl Strom führender Leiterbahnen, auch mit unterschiedlichen Leiterdurchmessern und Werkstoffen, je nach Anwendungsbereich.

## Patentansprüche

1. Flexibler Träger mit einer Basisschicht (12) aus Kunststoff und wenigstens einer mit elektrisch leitfähiger Farbe zumindest auf der Basisschicht (12) einseitig aufgedruckten, elektrisch leitfähigen Struktur (20),
**dadurch gekennzeichnet, dass**
die wenigstens eine elektrisch leitfähige Struktur (20) zwischen der Basisschicht (12) und wenigstens einer Deckschicht (14) aus Kunststoff und jede der gegebenenfalls weiteren elektrisch leitfähigen Strukturen (22) zwischen jeweils zwei aufeinander folgenden weiteren Deckschichten angeordnet und die Basisschicht (12) mit der wenigsten einen Deckschicht (14) und jede der gegebenenfalls weiteren Deckschichten mit den angrenzenden Deckschichten verbunden ist.

2. Flexibler Träger nach Anspruch 1, **dadurch gekennzeichnet, dass** die wenigstens eine Deckschicht (14) wenigstens eine weitere, mit elektrisch leitfähiger Farbe auf der wenigstens einen Deckschicht (14) aufgedruckte, elektrisch leitfähige Struktur (22) aufweist und zwischen den elektrisch leitfähigen Strukturen (20, 22) jeweils eine elektrisch isolierende Zwischenschicht (18) aus Kunststoff angeordnet ist.

3. Flexibler Träger nach Anspruch 2, **dadurch gekennzeichnet, dass** die wenigstens eine Deckschicht (14) mit der wenigstens einen weiteren elektrisch leitfähigen Struktur (22) von der wenigstens einmal um sich selbst gefalteten Basisschicht (12) mit der elektrisch leitfähigen Struktur (20) gebildet ist.

4. Flexibler Träger nach Anspruch 1 oder 2, **dadurch gekennzeichnet, dass** der Träger eingerollt ist.

5. Flexibler Träger nach einem der Ansprüche 2 bis 4, **dadurch gekennzeichnet, dass** die elektrisch leitfähigen Strukturen (20, 22) sich mehrfach kreuzende Leiterbahnen sind.

6. Flexibler Träger nach einem der Ansprüche 1 bis 5, **dadurch gekennzeichnet, dass** die wenigstens eine elektrisch leitfähige Struktur (20) aus übereinander gedruckten Teilstrukturen (20ₙ, 20ₙ₋₁) besteht und jede aufgedruckte Struktur (20ₙ) gegenüber dem Rand der darunter liegenden aufgedruckten Struktur (20ₙ₋₁) unter Bildung einer Stufe zurückversetzt ist.

7. Flexibler Träger nach einem der Ansprüche 1 bis 6, **dadurch gekennzeichnet, dass** die Basisschicht (12) und die wenigstens eine Deckschicht (14) oder bei weiteren Deckschichten zumindest die von der Basisschicht (12) am weitesten entfernte Deckschicht je eine Barriereschicht (16) als Durchtrittssperre für Wasserdampf aufweisen.

8. Flexibler Träger nach Anspruch 7, **dadurch gekennzeichnet, dass** die Barriereschicht (16) eine Schicht aus wenigstens einem der Stoffe Aluminium, Al₂O₃ oder SiOₓ mit 0.9 < x < 2, insbesondere 1.2 < x < 1.8, aufweist.

9. Flexibler Träger nach Anspruch 8, **dadurch gekennzeichnet, dass** die Barriereschicht (16) eine mit der Basisschicht (12) und der wenigstens einen Deckschicht (14) oder bei weiteren Deckschichten zumindest mit der von der Basisschicht (12) am weitesten entfernten Deckschicht verbundene und von der elektrisch leitfähigen Struktur (20) elektrisch getrennte Aluminiumfolie ist.

10. Flexibler Träger nach Anspruch 9, **dadurch gekennzeichnet, dass** die Aluminiumfolie auf der Aussenseite der Basisschicht (12) und der von der Basisschicht (12) am weitesten entfernten Deckschicht (14) angeordnet ist.

11. Flexibler Träger nach Anspruch 8, **dadurch gekennzeichnet, dass** die Barriereschicht (16) als aus dem Vakuum abgeschiedene Schicht innerhalb oder auf der Aussenseite der Basisschicht (12) und der Deckschicht (14) angeordnet ist.

12. Verfahren zum kontinuierlichen Aufdrucken elektrisch leitfähiger Strukturen (20, 22) mit einer elektrisch leitfähigen Farbe auf einen flexiblen Träger (10) aus Kunststoff, **dadurch gekennzeichnet, dass** der Träger (10) im Tiefdruckverfahren bedruckt wird.

13. Verfahren nach Anspruch 12, **dadurch gekennzeichnet, dass** die elektrisch leitfähigen Strukturen (20, 22) zur Erhöhung der elektrischen Leitfähigkeit mehrfach übereinander gedruckt werden.

14. Verfahren nach Anspruch 13, **dadurch gekennzeichnet, dass** der Rand jeder aufgedruckten Struktur (20ₕ) gegenüber dem Rand der darunter liegenden aufgedruckten Struktur (20ₙ₋₁) unter Bildung einer Stufe zurückversetzt ist.
